Europäisches Patentamt

European Patent Office

Office européen des brevets

(11) Publication number: **0 416 707 A1**

# EUROPEAN PATENT APPLICATION

(21) Application number: 90202355.5

(22) Date of filing: 05.09.90

(51) Int. Cl.5: **H01L 21/82**, H01L 27/108, H01L 29/788, H01L 21/336, H01L 21/3205, H01L 21/321

(30) Priority: 08.09.89 NL 8902254

(43) Date of publication of application:
13.03.91 Bulletin 91/11

(84) Designated Contracting States:
CH DE FR GB IT LI NL

(71) Applicant: N.V. Philips' Gloeilampenfabrieken
Groenewoudseweg 1
NL-5621 BA Eindhoven(NL)

(72) Inventor: Solo de Zaldivar, José
c/o Int. Octrooibureau B.V., Prof. Holstlaan 6
NL-5656 AA Eindhoven(NL)

(74) Representative: Houbiers, Ernest Emile Marie
Gerlach et al
INTERNATIONAAL OCTROOIBUREAU B.V.
Prof. Holstlaan 6
NL-5656 AA Eindhoven(NL)

(54) Method of manufacturing a semiconductor device comprising a field effect transistor and a capacitor.

(57) A method of manufacturing a semiconductor device comprising a semiconductor body (1), which is provided with a capacitor having first and second capacitance electrodes (21, 22). The first capacitance electrode (21) and the gate electrode (22) are both made of a polycrystalline silicon layer. According to the invention, after source and drain zones (31, 32) of the transistor have been formed on either side of the gate electrode (34) in the semiconductor body (1), a metal layer is provided, which is separated by a dielectric layer (20) from the first capacitance electrode (21). By means of a heat treatment, the second capacitance electrode (22) is formed from the metal layer on the dielectric layer and this second capacitance electrode comprises a high melting-point metal compound. In the same processing step, the source and/or the drain zone (31, 32) are provided with a connection electrode (35, 36), which consists at least in part of metal silicide.

FIG. 2

## METHOD OF MANUFACTURING A SEMICONDUCTOR DEVICE COMPRISING A FIELD EFFECT TRANSISTOR AND A CAPACITOR.

The invention relates to a method of manufacturing a semiconductor device comprising a semiconductor body of silicon, which is provided at a surface with an insulated gate field effect transistor and with a capacitor having first and second capacitance electrodes mutually separated by a dielectric layer, while at the surface a comparatively thick field oxide layer is formed which is provided locally with an opening, at the area of the opening a comparatively thin isolating layer is provided on the surface, from which a gate dielectric of the transistor is formed by masking and etching of a polycrystalline silicon layer, the first capacitance electrode of the capacitor and - on the gate dielectric -the gate electrode of the transistor are provided, at least the part of the polycrystalline silicon layer which constitutes the first capacitance electrode is covered with the dielectric layer, and source and drain zones of the transistor are formed by local doping on either side of the gate electrode in the semiconductor body.

The invention can be used in a wide range of integrated circuits, in which the combination of a capacitor and a field effect transistor is frequently employed. Particularly in so-called "switched capacitor" and (E)EPROM circuits is the invention very well applicable.

A method as described in the opening paragraph, is known from US PS No. 4,698,787, in which the manufacture of a transistor is described which constitutes a memory element of an EEPROM. The transistor comprises a floating gate electrode and a control electrode mutually separated by a dielectric layer. Such a transistor can be considered as a combination of a capacitor and a field effect transistor in one structure. The floating gate electrode constitutes both the insulating gate electrode of the field effect transistor and the first capacitance electrode of the capacitor, whose second capacitance electrode is constituted by the control electrode.

According to the known method, after a phophorus-doped polycrystalline silicon layer from which the floating gate electrode is formed has been provided and has been covered with the dielectric layer, a second polycrystalline silicon layer is provided for forming the control electrode. At the same time, gate electrodes of field effect transistors present elsewhere in the device are manufactured from the second polycrystalline silicon layer. Subsequently, the source and drain zones of the EEPROM transistor are provided by means of ion implantation on either side of the floating gate electrode in the semiconductor body, after which the assembly is covered with a glass layer and the source and drain zones are provided with connection electrodes.

The known method has the disadvantage that for the first capacitance electrode a layer, in this case the first polycrystalline silicon layer, should be provided, which is not used for the field effect transistors present elsewhere. This means that, starting from a manufacturing process for field effect transistors, in the known method at least an additional deposition, masking and etching step have to be carried out to be able to form the capacitor.

Moreover, the use of polycrystalline silicon for the second capacitance electrode has the disadvantage that, in order to obtain a sufficiently high electrical conduction, the electrode must have a comparatively large thickness, which is at the expense of the evenness of the topology of the device. The height differences associated therewith may give rise to a poor step coverage of layers to be provided later, more particularly of the ultimate metallization. In the most extreme case, interruptions in the wiring may result therefrom, which renders the device useless. Moreover, height differences lead to an increased spread in the width of wiring tracks to be etched later, which gives rise to undesired resistance variations

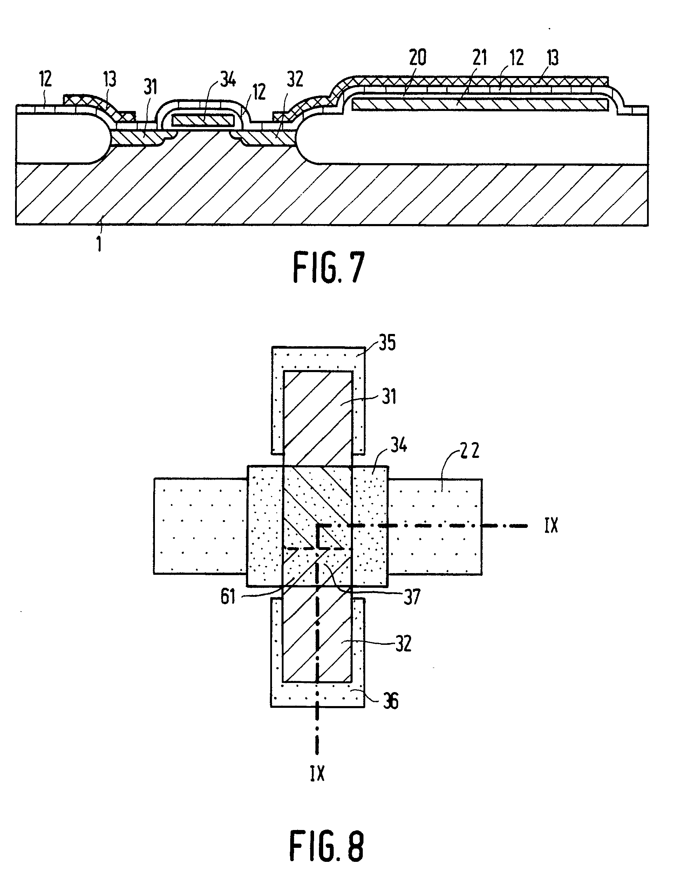

Such height differences may be considerably smaller if the second capacitance electrode consists of aluminium, as described in "Semiconductor Memories, B. Prince and G. Due-Gundersen, J. Wiley and Sons, 1985, p. 138, Fig. 7.14d", in which an EEPROM is shown comprising a transistor provided with an aluminium control electrode. Due to the considerably lower resistivity in comparison with that of silicon, an aluminium control electrode can be considerably thinner than a control electrode of silicon.

A disadvantage of a second capacitance electrode of aluminium, however, is that in this case the electrode cannot be provided until an often used glass layer, for example a TEOS, PSG or BPSG layer, has been deposited. Due to the comparatively low melting point of aluminium (aluminium already melts at about 660°C), the electrode is not capable of withstanding the comparatively high temperatures at which such a glass layer is generally formed.

In such a case, the second capacitance electrode should be provided on the dielectric layer of the capacitor via a window in the glass layer. In that case the window must be aligned with respect to the first capacitance electrode, in which event given alignment tolerances have to be taken into account, which requires space and makes the manufacturing process more complex.

The invention has inter alia for its object to provide a method, in which at least substantially entirely within an existing manufacturing process for a semiconductor device comprising a field effect transistor also a capacitor can be provided and in which the aforementioned disadvantages inherent in the two known methods are obviated.

According to the invention, a method of the kind mentioned in the opening paragraph is characterized in that, after the source and drain zones have been exposed at least in part, a metal layer is provided, which is separated by the dielectric layer from the first capacitance electrode, and in that a heat treatment is carried out during which the metal layer is converted at least in part into metal silicide at the area at which the layer is in contact with silicon, and in that the second capacitance electrode as well as a connection electrode to the source or the drain zone is formed from the at least partially converted metal layer.

Many modern manufacturing processes for field effect transistors permit of forming refractory metal compounds. In MOS IC's having a very high packing density, especially metal silicides are nowadays an almost indispensable addition to the more conventional metallization of aluminium. So-called salicide techniques ( s elf- ali gned sili cide ) offer the possibility of providing exposed silicon with a good conducting top layer of metal silicide without using a mask. And by means of so-called straps, small strips of metal silicide, it is possible to provide e.g. the source and drain zones of the transistors with connection electrodes, which are located at least in part on the field oxide. The invention can be carried out within such a manufacturing process without it being necessary for the manufacturing process to be extended at least essentially.

The metal compound of the second capacitance electrode may comprise, for example, like the connection electrodes of the source and drain zones, a metal silicide, but it is also possible that the second capacitance electrode is made of a different material, for example of a metal nitride, such as hafnium nitride, zirconium nitride or titanium nitride. According to a particular embodiment of the invention, which is characterized in that the heat treatment is carried out in a nitrogen-containing atmosphere so that on the dielectric layer the metal layer is converted at least partially into metal nitride from which the second capacitance electrode is etched, the last-mentioned possibility does not require any additional processing step.

Metal silicides and metal nitrides are in general very well capable of withstanding high temperatures so that, according to the invention, the second capacitance electrode can be provided before any glass layer. Consequently, the second capacitance electrode need not be provided via a window in the glass layer so that the afore-mentioned alignment tolerances are avoided and space is saved.

Moreover, at least substantially all metal silicides and the said metal nitrides have a resistivity which is at least one order lower than that of doped silicon. The second capacitance electrode of the invention can thus be provided in a considerably smaller thickness than an electrode of silicon without adversely affecting the conductivity thereof. This is favourable for the step coverage of layers to be provided later, which reduces the risk of interruptions therein, while it moreover leads to a more uniform width of wiring tracks to be etched later.

The invention will now be described more fully with reference to a few embodiments and a drawing. In the drawing:

Fig. 1 shows an electric equivalent circuit diagram of a base cell from a dynamic memory,

Fig. 2 is a cross-section of a semiconductor device comprising the base cell of Fig. 1 manufactured by the method according to the invention;

Figs. 3 to 7 show the semiconductor device of Fig. 2 at successive stages of manufacture according to the invention;

Fig. 8 is a plan view of a memory element of an EEPROM;

Fig. 9 is a cross-section taken on the line IX-IX of the memory element of Fig. 8;

Figs. 10 to 15 show the memory element of Figs. 8 and 9 at successive stages of manufacture according to the method of the invention.

The Figures are purely schematic and are not drawn to scale. More particularly, for the sake of clarity certain dimensions are greatly exaggerated. As far as possible, in the drawing corresponding parts are provided with the same reference numerals, while semiconductor material of the same conductivity type is cross-hatched in the same direction.

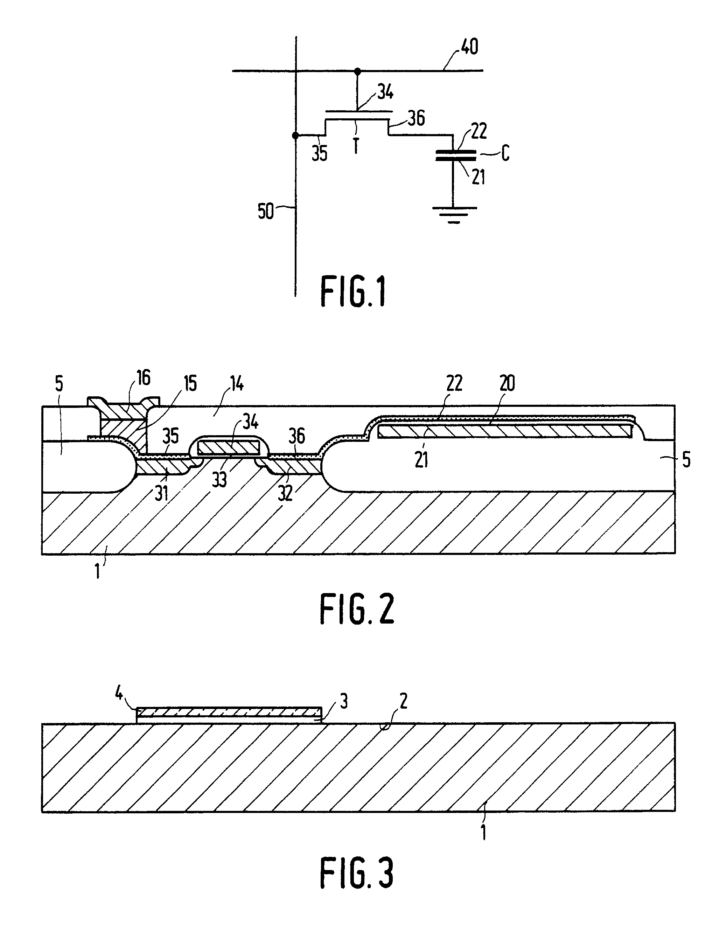

In a first embodiment, the method according to the invention is used for the manufacture of a semiconductor device provided with a dynamic memory, often designated by DRAM (Dynamic Random Access Memory). Figs. 1 and 2 show an electric equivalent circuit diagram and a cross-section, respectively, of a base cell of the memory. The base cell comprises a field effect transistor T having a source electrode 35, a drain electrode 36 and a gate electrode 34, as well as a capacitor C having a first capacitance electrode 21 and a second capacitance electrode 22. The base cell is connected between a bit line 50 and a word line 40 of the memory. The bit line 50 is coupled to the source electrode 35 and the word line 40 is coupled to the gate electrode 34 of the transistor. The drain electrode 36 of the transistor is connected to the second capacitance electrode 22 of the capacitor, whose first capacitance electrode 21 is applied to a fixed potential, in this case earth.

As can be seen in Fig. 2, the transistor is of the MIS (Metal-Insulator-Semiconductor) type and is provided in an opening in a field oxide layer 5. The transistor comprises source and drain zones 31 and 32, respectively, which are provided on either side of the gate electrode 34 in a semiconductor body 1. The gate electrode 34 is separated by a gate dielectric 33 insulated by a gate dielectric 33 from the part of the semiconductor body 1 located between the source and drain zones 31, 32, which part constitutes a channel region of the transistor.

The capacitor C is provided on the field oxide layer 5, the second capacitance electrode 22 being integral with the drain electrode 36 of the transistor. The first capacitance electrode 21 can be connected to earth outside the plane of drawing.

For the manufacture of the device of Fig. 2, the starting member is a semiconductor body 1 of boron-doped silicon. After the surface 2 of the semiconductor body 1 has been cleaned, it is exposed to a light thermal oxidation so that a thin silicon oxide layer 3 is formed. The silicon oxide layer is then provided with an oxidation mask 4 of silicon nitride, which defines the pattern of the field oxide layer to be formed (see Fig. 3). The silicon oxide layer located under the mask 4 serves to relief stresses between the mask 4 and the semiconductor body 1, for which purpose, for example, a silicon oxynitride layer may also be used.

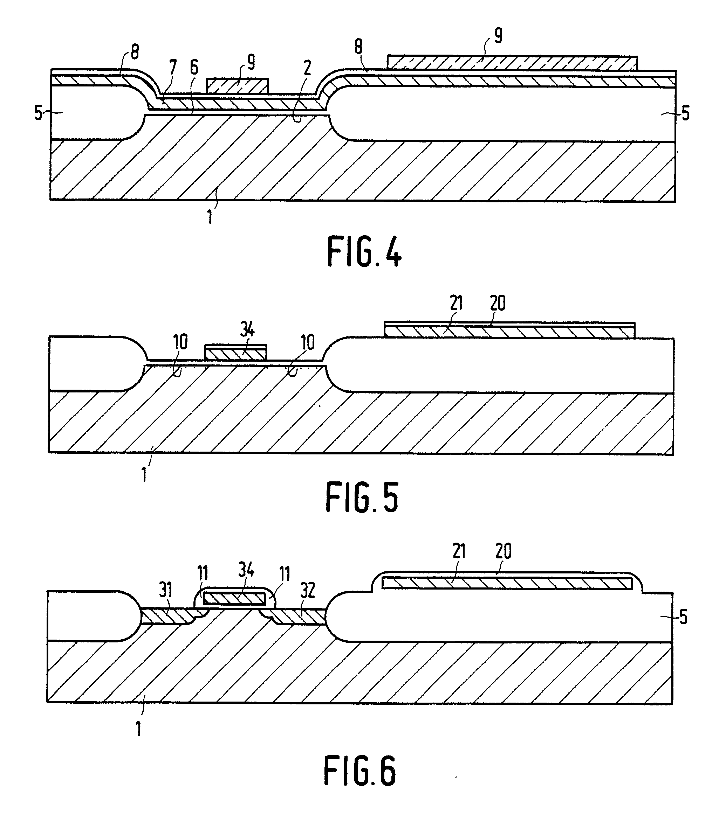

The assembly is subjected to a thermal oxidation during which a comparatively thick field oxide layer 5 is formed at the surface 2 (see Fig. 4), which is partly sunken into the semiconductor body 1 and has an opening, in which the transistor will be provided at a later stage.

After the nitride mask 4 and the oxide layer 3 have been removed, the semiconductor body 1 is provided with a comparatively thin isolating layer 6 of silicon oxide, from which the gate dielectric of the transistor is formed. The silicon oxide layer 6 has a thickness of about 20 nm. Subsequently, the assembly is covered with an about 450 to 500 nm thick polycrystalline silicon layer 7, which is doped comparatively heavily with phosphorus. An about 25 nm thick dielectric layer 8 of silicon oxide is provided on the silicon layer 7. For the dielectric layer 8, another insulator may also be used, such as, for example, silicon nitride or silicon oxynitride. It is also possible to provide instead of a single dielectric layer a structure of a plurality of layers. A known example thereof is a so-called ONO layer comprising a three-layer structure successively of a silicon o xide layer, a silicon n itride layer and again a silicon o xide layer. Subsequently, an etching mask 9 is provided, which defines the gate electrode and the first capacitance electrode to be formed (see Fig. 4).

Whilst masking with the mask 9, the uncovered parts of the silicon oxide layer 8 and then of the silicon layer 7 are etched away. Thus, in a single processing step, both the gate electrode 34 of the transistor and the first capacitance electrode 21 of the capacitor are formed from the silicon layer 7 (see Fig. 5). The first capacitance electrode 21 is covered with a part 20 of the silicon oxide layer 8.

After the etching mask 9 has been removed, arsenic is implanted into the semiconductor body on either side of the gate electrode 34, which is indicated in Fig. 5 by a dotted line 10. Both the gate electrode 34 and the field oxide layer 5 mask against the implantation. Instead of arsenic, also another n -type dopant, such as phosphorus, may be used.

A comparatively thick silicon oxide layer is then deposited on the assembly and then etched away anisotropically, as a result of which ultimately only spacers 11 located along the gate electrode 34 and the first capacitance electrode 21 are left (see Fig. 6).

Subsequently, a second implantation with arsenic is carried out at a higher energy and a higher dose than the first implantation. During this implantation, the edge portions 11 also mask so that the arsenic is introduced into the semiconductor body 1 at a certain distance from the gate electrode 34. Due to the higher energy of the implantation, the arsenic moreover penetrates to a slightly larger depth into the semiconductor body 1 than the impurity 10 already present. Also for the second implantation, instead of arsenic another type of impurity may be chosen. Subsequently, a heat treatment is carried out, during which the implanted impurity can diffuse further into the semiconductor body 1, as a result of which a source zone 31 and a drain zone 32 of the transistor are formed on either side of the gate electrode. The structure now obtained is shown in Fig. 6.

By means of a light etching treatment, the source and drain zones 31, 32 are now exposed, after which the assembly is covered with an about 40 nm thick layer of titanium 12, which is separated by the silicon oxide layer 20 from the first capacitance electrode 21 (see Fig. 7). The titanium layer 12 has then deposited on it a layer of amorphous silicon, from which strips 13 are etched at the area of the second capacitance electrode to be formed and the source and drain zones 31, 32. Subsequently, a heat treatment is carried out, in which the temperature is increased to about 550 to 600°C. The titanium layer 12 is then converted at least for the major part into titanium silicide at the area at which the layer is in contact with silicon. The unconverted titanium can then be etched away selectively with respect to the titanium silicide. A suitable etchant for this purpose is, for example, a solution of ammonium hydroxide and hydrogen peroxide in water. Thus, according to the invention, the second capacitance electrode 22, the source electrode 35 and the drain electrode 36 are formed from titanium silicide in a single processing step (see Fig. 2).

Otherwise, it should be noted here that, where in the present Application the term "metal compound" is used, for example a metal nitride or a metal silicide, this term is to be understood in principle to mean not only a single stoichiometric compound, but any material which contains the elements of the compound in any ratio. In this case, the titanium silicide will consist mainly of titanium disilicide ($TiSi_2$), but may contain also other silicides, such as, for example, titanium monosilicide (TiSi) and pentatitanium trisilicide ($Ti_5Si_3$).

Instead of titanium, another metal may also be used, which can be silicidized, such as, for example, tungsten, tantalum, cobalt or molybdenum.

The assembly is now covered with a comparatively thick glass layer 14 of b orophospho s ilicate g lass (BPSG), which serves for the passivation of the device. For this layer 14, also other kinds of glass may be used, such as pure silicon oxide, for example TEOS, which is applied by deposition from the gaseous phase from t etra e thyl o rtho s ilicate or p hospho s ilicate g lass (PSG). These glasses generally used for the passivation layer 14 are formed by deposition from the gaseous phase at a temperature of 650 to 900°C, depending upon the kind of glass. Subsequently, a heat treatment is carried out to cause the glass to flow in order that a better step coverage is obtained. In the case of the BPSG used here, this requires a temperature of 800 to 900°C, while with PSG the temperature must be increased to even more than 1150°C. Due to the high melting point of titanium silicide (about 1540°C), which is used here according to the invention for the second capacitance electrode 22, this does not unfavourably influence the second capacitance electrode 22 already provided. If according to a known method aluminium should have been used for the second capacitance electrode having a melting point of about 600°C, the electrode could be provided only after the glass layer 14, which would require given alignment tolerances of the window then to be used and hence additional space.

Another advantage of the material used for the second capacitance electrode in accordance with the invention is that it has a considerably lower resistivity than doped silicon, which is used in another known method for the second capacitance electrode. An electrode of silicon having a resistivity at least of the order of a thousand $\mu\Omega.cm$, generally has a thickness of about 500 nm. For the same conductivity, the electrode used here consisting of titanium silicide having a resistivity of about 13 to $16\mu\Omega.cm$ can be a factor 100 thinner. In this example, the second capacitance electrode has a thickness of about 40 to 50 nm so that the capacitor is only little higher than the first capacitance electrode having a thickness of about 450 to 500nm. This is favourable for the step coverage of the glass layer 14, as a result of which a comparatively flat topology is obtained.

The glass layer 14 is provided with contact windows, such as, for example, at the area of the source electrode. The contact windows are filled at least in part with tungsten 15, as the case may be preceded by a thin layer of titanium-tungsten, which increases the reliability of ultimate electrical connection. Subsequently, an aluminium layer is provided on the assembly and a wiring 16 is etched from this aluminium layer. Due to the flat topology of the device as a result of the small thickness of the second capacitance electrode, the etching treatment attacks comparatively homogeneously the aluminium layer. The wiring tracks 16 etched thus have a uniform width, more particularly also at the area at which the wiring crosses the capacitor, as a result of which undesired resistance variations therein are limited. The structure obtained is shown in Fig. 2.

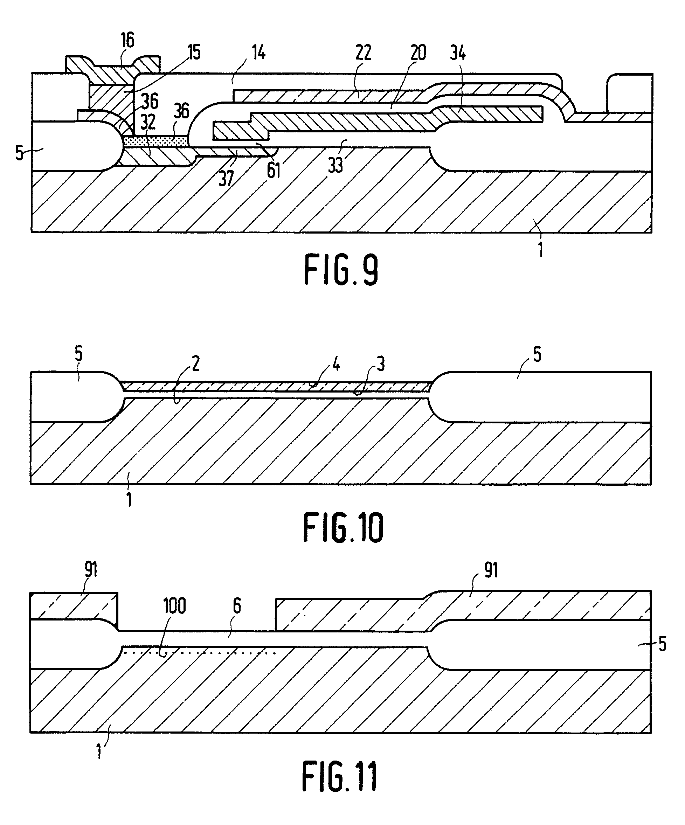

In a second embodiment, the method of the invention is used for manufacturing an EEPROM ( E lectrically E rasable P rogrammable R ead-o nly M emory). Fig. 8 is a plan view and Fig. 9 is a cross-section of a memory element of an EEPROM comprising a transistor having an n -type source zone 31 and an n -type drain zone 32, which are provided on either side of a floating gate electrode 34 of the transistor in a p -type semiconductor body 1 of silicon. The floating gate electrode is separated by an about 20 nm thick gate dielectric of silicon oxide from the part of the semiconductor body 1 located between the source and drain zones 31 and 32, which part forms a channel region of the transistor. The floating gate electrode 34 is partly located above an injector region 37, which adjoins the drain zone 32 of the transistor, and is separated therefrom by a thin layer 61 of so-called tunnel oxide having a thickness of about 10 nm. Such a thin silicon oxide layer permits Fowler-Nordheim tunneling of charge carriers between the injector region 37 and the floating gate electrode 34. This mechanism is used to program and to erase the transistor. For a more detailed description of the operation of an EEPROM, reference may be made here to the aforementioned handbook "Semiconductor Memories" by B. Prince and G. Due-Gundersen. The floating gate electrode 34 is covered with an about 50 nm thick silicon oxynitride layer 20, on which a control electrode 22 of titanium silicide is provided. The transistor can be considered as a combination of a field effect transistor having an insulated floating gate electrode 34 and a capacitor in one structure. The floating gate electrode 34 and the control electrode 22 form the first and the second capacitance electrode, respectively, of the capacitor. By applying a suitable voltage to the control electrode 22, whilst utilizing the capacitive coupling with the floating electrode 34, the transistor can be erased and programmed by tunneling of charge carriers through the silicon oxide layer 61.

For the manufacture of the device shown in Figs. 8 and 9, there is started from a semiconductor body 1 of silicon, on a surface 2 of which are successively formed a thin silicon oxide layer 3 and an oxidation mask 4 of silicon nitride. Subsequently, the assembly is exposed for a few hours to an oxidizing medium of steam which causes a comparatively thick field oxide layer 5 to be grown at the surface 2 (cf. Fig. 10).

After the oxidation mask and the underlying oxide layer 3 have been removed, an about 20 nm thick silicon oxide layer 6 is grown in an opening in the field oxide layer 5 on the exposed silicon (cf. Fig. 11), from which oxide layer the gate dielectric of the transistor will be formed at a later stage. An implantation mask 91 is then provided on the silicon oxide layer 6, after which arsenic is implanted within the opening in the field oxide layer 5 into the semiconductor body 1 for forming the comparatively heavily doped n -type injector region of the transistor. The implanted dopant is indicated in Fig. 11 by a dotted line 100.

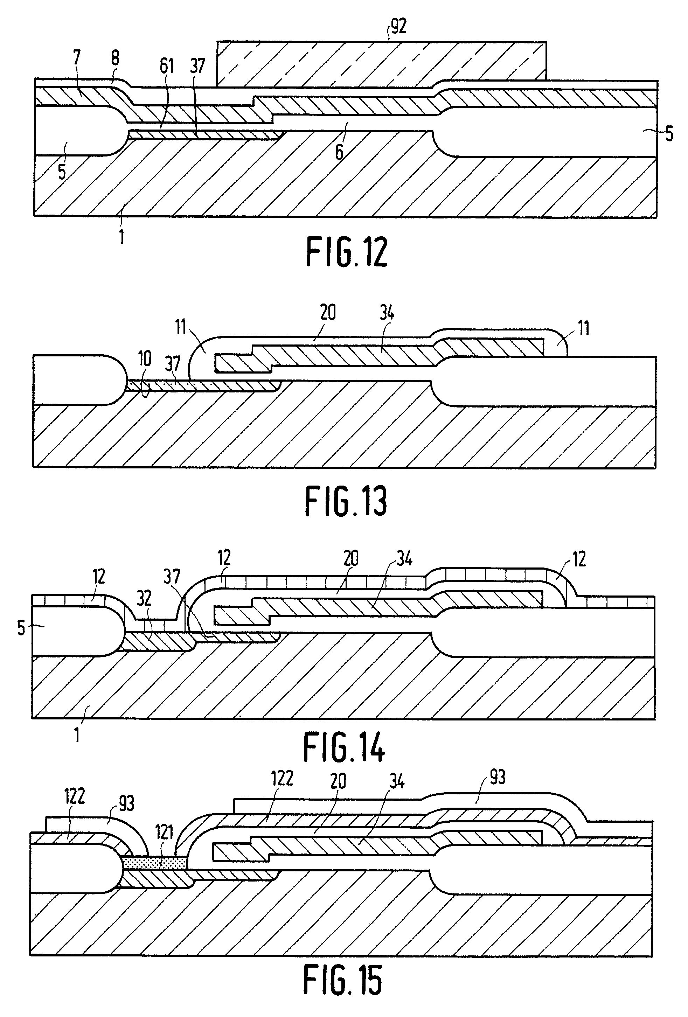

Subsequently, the silicon oxide layer 6 is etched away at the area of the injector region to be formed, after which a second thermal oxidation is carried out, in which a thin about 10 nm thick silicon oxide layer 61 is formed on the exposed part of the semiconductor body 1 (cf. Fig. 12), as a result of which Fowler-Nordheim tunneling of charge carriers is possible. During the thermal oxidation, the arsenic 100 diffuses further into the semiconductor body 1, as a result of which the injector region 37 is formed.

The method according to the invention may also be used for the manufacture of an EPROM ( E lectrically P rogrammable R ead-O nly M emory), in which instead of Fowler-Nordheim tunneling use is made of tunneling of so-called "hot" charge carriers, which are accelerated by the depletion field around the drain zone, in order to program the transistor. The transistor may then be erased, for example, by ultraviolet radiation. In this case, no tunnel oxide and no injector region need be formed so that the processing steps described above then need not be carried out.

Subsequently, an about 450 to 500 nm thick n -type polycrystalline silicon layer 7 is provided on the assembly. By LPCVD, an about 50 nm thick dielectric layer of silicon oxynitride 8 is provided on the silicon layer 7.

The silicon oxynitride layer 8 and the silicon layer 7 are then patterned by etching by means of a mask 92 for forming a floating gate electrode 34 covered by a part 20 of the silicon oxynitride layer 8 (of. Fig. 13). Instead of silicon oxynitride, also a layer of a different dielectric material, for example silicon oxide or silicon nitride, or an ONO layer, may be used. Due to the about two times larger dielectric constant of silicon oxynitride in comparison with silicon oxide, a silicon oxynitride layer can be two times thicker with the same capacitive coupling than a silicon oxide layer. A thicker layer can be more readily provided in a uniform thickness and leads to a lower leakage current in the ultimate transistor. An ONO layer has the same advantage, but in contrast with an ONO layer a silicon oxynitride layer can be provided in one processing step. Therefore, silicon oxynitride is preferred here.

Subsequently, arsenic is implanted into the semiconductor body on either side of the floating gate electrode 34, which is indicated in Fig. 13 by a dotted line 10. A comparatively dense silicon oxide layer is then provided on the assembly for instance by chemical vapour deposition. The silicon oxide layer is then etched anisotropically, after which only edge portions 11 of said layer located along the floating gate electrode 34 are left.

Whilst masking the edge portions 11 and the gate electrode, a next arsenic implantation is carried out at a higher dose and a higher energy than the preceding implantation. After a short heat treatment, in which the implanted arsenic can diffuse further into the substrate, source and drain zones on either side of the floating gate electrode 34 are formed of (cf. Fig.14). The source zone lies outside the plane of the drawing and is therefore not shown in Fig. 14. The drain zone 32 and the injector region 37 of the transistor adjoin each other so that no separate electrical connection between them has to be provided. After a short etching step, in which the surface of the source and drain zones 32 is exposed, the assembly is covered with an about 40 nm thick metal layer 12 of titanium, which is separated by the silicon oxynitride layer 20 from the floating gate electrode 34 (cf. Fig. 14). The assembly is then subjected to a heat treatment at about 600°C in a nitrogen atmosphere. The titanium 12 is then converted into titanium silicide 121 locally at the area at which it is in contact with silicon (cf. Fig. 15). For the remaining part, especially on the silicon oxynitride layer 20, the titanium reacts with nitrogen whilst forming titanium nitride 122. So at this stage a uniform conducting layer partly of titanium silicide and partly of titanium nitride is obtained. Subsequently, by means of a mask 93, the second capacitance electrode 22 as well as source and drain electrodes 35, 36 are etched from said conducting layer (of. Figs. 8 and 9). With a proper etchant titanium nitride is selectively etchable with respect to titanium silicide which may be taken advantage of. As mentioned before the second capacitance electrode 22 constitutes the control gate of the EPROM transistor.

Like titanium silicide, titanium nitride is very capable of withstanding high temperature. The melting point of titanium nitride is about 2930°C. Like titanium silicide, titanium nitride has with a resistivity of about 21.7 $\mu\Omega$.cm a resistivity which lies far below that of doped silicon.

Otherwise, in the present embodiment, in stead of titanium also other metals may be used, which may be silicidized and of which the corresponding nitride has a comparatively low resistivity, such as, for example, zirconium or tantalum.

A passivation layer 14 of phospho-silicate glass (PSG) is provided on the assembly by deposition from the gaseous phase, after which the assembly is heated to about 1100°C to cause the glass to flow. Because of the very well heat resistance of the control gate 21, it is not adversely affected by this last treatment. The glass layer is provided with contact windows which are filled at least in part with tungsten 15. An aluminum layer is then applied by sputtering, from which by means of a mask a wiring 16 is etched. Thus, the EPROM-transistor shown in Figs. 8 and 9 is obtained which is relatively flat due to the small thickness of the control gate 22 and which can be much smaller than conventional EPROM transistors due to the fact that the control gate 22 could be provided before the glass layer 14.

It will be appreciated that the invention is not limited to the embodiments described above, but that within the scope of the invention many further variations are possible for those skilled in the art. In the first place, in the embodiments described, the conductivity types may be replaced by the opposite types.

In the last embodiment, simultaneously with the EPROM transistor a separate field effect transistor and/or a separate capacitor may be provided. Such a field effect transistor may be used, for example, as access transistor in the EPROM or may form part of a logic circuit integrated elsewhere in the semiconductor body. The last-mentioned case is often designated in literature as "embedded EPROM".

The invention may also be used advantageously in other types of integrated circuits, such as, for example, in aforementioned so-called "switched capacitor" circuits. In general, the invention may be used in all integrated circuits which comprise both capacitors and field effect transistors.

## Claims

1. A method of manufacturing a semiconductor device comprising a semiconductor body of silicon, which is provided at a surface with an insulated gate field effect transistor and with a capacitor having a first and a second capacitance electrode mutually separated by a dielectric layer, while at the surface a comparatively thick field oxide layer is formed which is locally provided with an opening, a comparatively thin isolating layer is provided on the surface at the area of the opening, from which layer a gate dielectric of the transistor is formed, the first capacitance electrode of the capacitor and - on the gate dielectric - the gate electrode of the transistor are provided by masking and etching of a polycrystalline silicon layer, at least the part of the polycrystalline silicon layer which constitutes the first capacitance electrode is covered by the dielectric layer, and source and drain zones of the transistor are formed by local doping on either side of the gate electrode in the semiconductor body, characterized in that, after the source and drain zones have been exposed at least in part, a metal layer is provided, which is separated by the dielectric layer from the first capacitance electrode, and in that a heat treatment is carried out during which the metal layer is converted at least in part into metal silicide at the area at which the layer is in contact with silicon, and in that the second capacitance electrode as well as a connection electrode to the source or the drain zone is formed from the at least partially converted metal layer.

2. A method as claimed in Claim 1, characterized in that for the metal layer a refractory metal is used from a group comprising titanium, hafnium, tantalum, cobalt, molybdenum and tungsten.

3. A method as claimed in Claim 1 or 2, characterized in that the heat treatment is carried out in a nitrogen-containing atmosphere so that on the dielectric layer the metal layer is converted at least partially into metal nitride, from which the second capacitance electrode is etched.

4. A method as claimed in Claim 1 or 2, characterized in that, after the metal layer has been provided, silicon strips are provided thereon at the area of the first capacitance electrode and the source and/or drain zone, and in that then during the heat treatment the strips are converted at least for the major part into metal silicide for forming the second capacitance electrode and the one or more connection electrodes.

5. A method as claimed in any one of the preceding Claims, characterized in that the dielectric layer is also provided on the gate electrode of the field effect transistor, after which simultaneously with the second capacitance electrode a conductor track is formed, which is separated by the dielectric layer from the gate electrode.

6. A method as claimed in anyone of the preceding Claims, characterized in that after the second capacitance has been provided a glass layer is deposited in the whole which subsequently is provided with contact windows and that a metallization pattern is formed on the glass layer contacting the second capacitance electrode or a connection electrode through a contact window.

FIG.1

FIG.2

FIG.3

FIG.4

FIG.5

FIG.6

FIG. 7

FIG. 8

EP 0 416 707 A1

FIG.9

FIG.10

FIG.11

FIG.12

FIG.13

FIG.14

FIG.15

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 811 078 (TEXAS INSTRUMENTS)<br>* Figures 2a,4a; page 19, line 1 - page 21, line 17; figure 1; page 13, line 26 - page 15, line 54; page 24, line 20; page 22, lines 63-67 *<br>— — — | 1-3,5,6 | H 01 L 21/82<br>H 01 L 27/108<br>H 01 L 29/788<br>H 01 L 21/336<br>H 01 L 21/3205 |
| Y | | 4 | H 01 L 21/321 |
| Y | INTERNATIONAL ELECTRON DEVICES MEETING, San Francisco, CA, 9th - 12th December 1984, pages 118-121, IEEE, New York, US; D.C. CHEN et al.: "A new device interconnect scheme for sub-micron VLSI"<br>* Whole document *<br>— — — | 4 | |
| A | EP-A-0 191 612 (FUJITSU LTD)(20-08-1986)<br>* Figure 6; page 20, lines 17-23 *<br>— — — | 1,4,6 | |
| A | PATENT ABSTRACTS OF JAPAN, vol. 9, no. 106 (E-313)[9106], 10th May 1985;<br>& JP-A-59 231 853 (TOSHIBA K.K.) 26-12-1984<br>* Abstract; figure *<br>— — — | 1,2 | |
| A | EP-A-0 253 741 (D. BOIS)(20-01-1988)<br>* Figure 2; abstract *<br>— — — — — | 1 | |

| TECHNICAL FIELDS SEARCHED (Int. Cl.5) |
|---|
| H 01 L |

The present search report has been drawn up for all claims

| Place of search | Date of completion of search | Examiner |
|---|---|---|
| The Hague | 06 December 90 | GELEBART J.F.M. |